# EUROPÄISCHE PATENTSCHRIFT

(11) **EP 2 186 387 B1**
(45) Veröffentlichungstag und Bekanntmachung des Hinweises auf die Patenterteilung: **16.09.2015**
(21) Anmeldenummer: 08775202.8
(22) Anmeldetag: 18.07.2008
(51) Int. Cl.: H01H 15/04

(54) **GEHÄUSE FÜR EINE ELEKTRISCHE/ELEKTRONISCHE SCHALTUNG**
HOUSING FOR AN ELECTRICAL/ELECTRONIC CIRCUIT
BOÎTIER POUR CIRCUIT ÉLECTRIQUE/ÉLECTRONIQUE

(30) Priorität: 26.07.2007 DE 102007035094
(43) Veröffentlichungstag der Anmeldung: 19.05.2010
(73) Patentinhaber: Robert Bosch GmbH, 70442 Stuttgart (DE)
(72) Erfinder: HENNEL, Udo, 74343 Sachsenheim (DE); ADAMIS, Ivan, H-1089 Budapest (HU)
(86) Internationale Anmeldenummer: PCT/EP2008/059425
(87) Internationale Veröffentlichungsnummer: WO 2009/013227

(56) Entgegenhaltungen:
- EP-A- 1 313 359
- EP-A- 1 784 066
- DE-A1-102006 053 114
- DE-U1- 8 408 092
- US-A- 3 987 258

## Beschreibung

Die Erfindung betrifft ein Gehäuse für eine elektrische/elektronische Schaltung, mit zumindest einer elektrischen Steck-Anschlussvorrichtung und mindestens einem Druckausgleichselement, das eine semipermeable Membran aufweist.

### Stand der Technik

Gehäuse für elektrische/elektronische Schaltungen sind im Stand der Technik bekannt. Insbesondere im Kraftfahrzeugbau werden sie für elektronische Schaltungen von Steuergeräten eingesetzt, die vor äußeren Einflüssen geschützt werden müssen. Von besonderer Bedeutung ist dabei, dass das Gehäuse die Schaltung abdichtet, so dass keine Flüssigkeit in das Gehäuse eindringen kann. Im Betrieb werden das Gehäuse und die Schaltung jedoch häufig großen Temperatur- und Druckschwankungen ausgesetzt, die die verwendeten Dichtungen und Verbindungsstellen des abgedichteten Gehäuses belasten. Um derartige Belastungen zu vermeiden, wird im Stand der Technik ein Druckausgleich zwischen der Umgebungsluft und dem Innern des Gehäuses durch ein Druckausgleichselement mit mindestens einer semipermeablen Membran gewährleistet, die im Regelfall direkt auf dem Gehäuse, beziehungsweise an einer Öffnung des Gehäuses befestigt ist. Die semipermeable Membran lässt zum Beispiel Luft und Wasserdampf passieren, hält jedoch Schmutz, Salz und Wasser vom Innern des Gehäuses fern. Da die semipermeable Membran sehr empfindlich ist, bedarf sie grundsätzlich eines mechanischen Schutzes in Form eines Schutzelements, um eine Beschädigung der Membran und damit eine Undichtigkeit des Gehäuses zu vermeiden.

Solch ein Gehäuse für eine elektronische Schaltung mit einer Anschluss- und einer Belüftungseinheit ist beispielsweise in der Offenlegungsschrift EP 1784066 A1 gezeigt. Die Belüftungseinheit weist hierbei eine luftdurchlässige Schicht auf, die von einer Schutzkappe abgedeckt ist, wobei die Schutzkappe wiederum eine Öffnung aufweist. Die Anschlusseinheit ist auf der Vorderseite des Gehäuses angeordnet, wohingegen die Belüftungseinheit auf der Oberseite des Gehäuses angeordnet ist.

### Offenbarung der Erfindung

Das erfindungsgemäße Gehäuse weist zumindest eine elektrische Steck-Anschlussvorrichtung und ein die Membran abdeckendes Schutzelement auf, wobei das Schutzelement neben der Steck-Anschlussvorrichtung angeordnet ist und mindestens eine Druckausgleichsöffnung aufweist, die im Wesentlichen in Richtung auf die Steck-Anschlussvorrichtung weist. Es ist also vorgesehen, dass das Druckausgleichselement beziehungsweise das Schutzelement des Druckausgleichselement neben der Steck-Anschlussvorrichtung angeordnet ist.

Dies hat gegenüber einem frei auf dem Gehäuse angeordneten Druckausgleichselement den Vorteil, dass durch das zumindest eine benachbarte Element, wie der Steck-Anschlussvorrichtung und/oder einem mit der Steck-Anschlussvorrichtung verbundener Stecker, ein direkter "Zugriff" auf die Membran verhindert wird. Unter der elektrischen Steck-Anschlussvorrichtung ist hierbei eine Vorrichtung zu verstehen, an die mechanisch ein Stecker angeschlossen beziehungsweise eingesteckt oder aufgesteckt werden kann, wodurch elektrische Kontakte der Steck-Anschlussvorrichtung und des Steckers miteinander wirkverbunden werden. Dadurch, dass die Druckausgleichsöffnung des Schutzelements in Richtung auf die Steck-Anschlussvorrichtung weist, wird ein direkter Zugriff auf die Membran verhindert. Insbesondere, wenn ein Stecker mit der Steck-Anschlussvorrichtung gekuppelt ist, wird die Membran beziehungsweise das Druckausgleichselement von der Steck-Anschlussvorrichtung und/oder dem Stecker abgedeckt beziehungsweise geschützt. Schmutz und/oder eine Flüssigkeit, wie zum Beispiel Wasser, könnten so nicht ohne weiteres zu der Membran gelangen, wodurch letztere wirkungsvoll geschützt ist und ihr dauerhafte Funktion gewährleistet wird.

Vorteilhafterweise steht die Steck-Anschlussvorrichtung von dem Gehäuse, insbesondere von einer nach außen weisenden Oberfläche des Gehäuses vor. Das bedeutet, dass von der nach außen weisenden Oberfläche des Gehäuses die Steck-Anschlussvorrichtung absteht beziehungsweise herausragt und dadurch ein vorstehendes Element des Gehäuses bildet. Das daneben angeordnete Druckausgleichselement wird dadurch wirkungsvoll vor äußeren Einflüssen geschützt, unabhängig davon, ob ein Stecker mit der Steck-Anschlussvorrichtung verbunden ist. Vorteilhafterweise weist die Steck-Anschlussvorrichtung eine Aufnahme für einen Stecker auf, die durch mindestens ein vorstehenden Haltevorsprung gebildet wird. Zeckmäßigerweise ist das Haltevorsprung der Druckausgleichsöffnung beziehungsweise die Druckausgleichsöffnung dem Halteelement zugewandt, um einen direkten Zugriff auf die semipermeable Membran zu verhindern. Steht die Steck-Anschlussvorrichtung nicht von dem Gehäuse vor, so bildet ein in die Steck-Anschlussvorrichtung eingesteckter Stecker den gleichen Schutz für das Druckausgleichselement beziehungsweise die semipermeable Membran.

Bevorzugt ist die Steck-Anschlussvorrichtung einstückig mit dem Gehäuse ausgebildet, so dass keine Zusätzlichen Dichtelemente zum Anbringen der Steck-Anschlussvorrichtung an dem Gehäuse notwendig sind. Darüber hinaus kann das Druckausgleichselement beziehungsweise die Druckausgleichsöffnung besonders nahe an der Steck-Anschlussvorrichtung angeordnet werden.

Nach einer Weiterbildung der Erfindung ist das Schutzelement als Schutzkappe ausgebildet. Diese überdeckt die semipermeable Membran vorteilhafterweise derart, dass zwischen der Membran und der Schutzkappe ein Ausgleichsraum gebildet ist, der ein Bewegen der Membran aus ihrer Ruhelage heraus erlaubt. Zweckmäßigerweise ist die Druckausgleichsöffnung des Schutzelements beziehungsweise der Schutzkappe dem Ausgleichsraum zugeordnet, so dass ein Druckausgleich gewährleistet ist. Die Schutzkappe steht bevorzugt von der nach außen weisenden Oberfläche des Gehäuses hervor und weist eine die semipermeable Membran umgebende Seitenwand auf, in der vorteilhafterweise die Druckausgleichsöffnung ausgebildet ist. Vorteilhafterweise ist die Schutzkappe einstückig mit dem Gehäuse ausgebildet.

Erfindungsgemäß ist die semipermeable Membran geneigt angeordnet. Wobei sich die Neigung im Wesentlich auf die Ausrichtung der semipermeablen Membran zur nach außen weisenden Oberfläche des Gehäuses bezieht. Dies hat den Vorteil, dass für den Fall, dass einmal Flüssigkeit und/oder Schmutz auf die semipermeable Membran geraten ist, die Flüssigkeit und/oder der Schmutz aufgrund der Neigung der semipermeablen Membran bei fast allen Einbaulagen des Gehäuses von der Membran abläuft. Zweckmäßigerweise ist die Neigung derart ausgerichtet, dass ablaufende Flüssigkeit und/oder Schmutz durch die Druckausgleichsöffnung aus dem Druckausgleichselement herausgelangt. Mit anderen Worten ist also die Druckausgleichsöffnung vorteilhafterweise der niedrigsten Stelle der semipermeablen Membran zugeordnet. Besonders bevorzugt ist die semipermeable Membran in Bezug auf den eingebauten Zustand des Gehäuses geneigt ausgerichtet.

Vorteilhafterweise ist das gesamte Druckausgleichselement oder zumindest der die semipermeable Membran umschließende Bereich des Gehäuse wie die semipermeable Membran geneigt ausgebildet, sodass sich in der näheren Umgebung der semipermeablen Membran kein Schmutz oder Flüssigkeit ansammeln kann.

Schließlich ist vorgesehen, dass die semipermeable Membran an dem Gehäuse durch eine Schweißung, Klebung, Pressung und/oder mittels einer Stoffumspritzung befestigt ist beziehungsweise gehalten wird.

Nach einer Weiterbildung der Erfindung ist das Gehäuse als Messerleiste ausgebildet.

Ferner betrifft die Erfindung ein Steuergerät, insbesondere eines Kraftfahrzeugs, mit einem wie vorstehend beschriebenen Gehäuse.

### Kurze Beschreibung der Zeichnungen

Im folgenden soll die Erfindung anhand mehrerer Figuren näher erläutert werden. Dazu zeigen
- Figur 1: ein Ausführungsbeispiel eines erfindungsgemäßen Gehäuses mit einem Druckausgleichselement,
- Figur 2: eine Detailansicht des Druckausgleichselements und
- Figur 3: eine Schnittansicht des Druckausgleichselements.

### Ausführungsform(en) der Erfindung

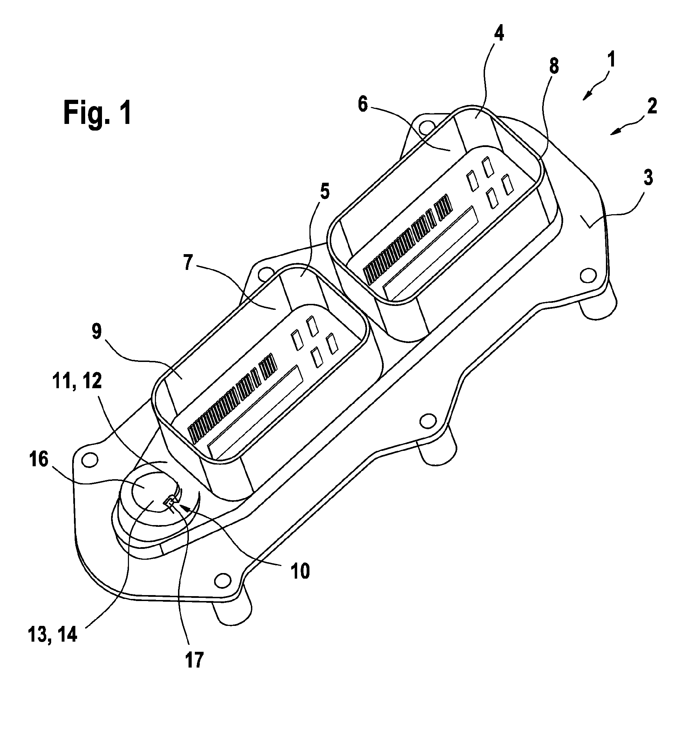

Die Figur 1 zeigt in einer perspektivischen Darstellung ein beispielhaftes Gehäuse 1 eines hier nicht dargestellten Steuergerät eines Kraftfahrzeugs. Das Gehäuse 1 ist in dem vorliegenden Ausführungsbeispiel als eine Messerleiste 2 ausgebildet und weist auf seiner nach außenweisenden Oberfläche 3 zwei nebeneinander angeordnete Steck-Anschlussvorrichtungen 4 und 5 auf, über die eine Schaltung des Steuergeräts elektrisch kontaktiert werden kann. Die Steck-Anschlussvorrichtungen 4 und 5 weisen jeweils eine Anschluss-Aufnahme 6 beziehungsweise 7 für einen Anschluss-Stecker auf. Die Anschluss-Aufnahmen 6 und 7 werden von jeweils einem, von der Oberfläche 3 abstehenden Haltevorsprung 8 beziehungsweise 9 gebildet.

Auf der zu der Steck-Anschlussvorrichtung 4 gegenüberliegenden Seite der Steck-Anschlussvorrichtung 5 ist ein Druckausgleichselement 10 neben der Steck-Anschlussvorrichtung 5 angeordnet.

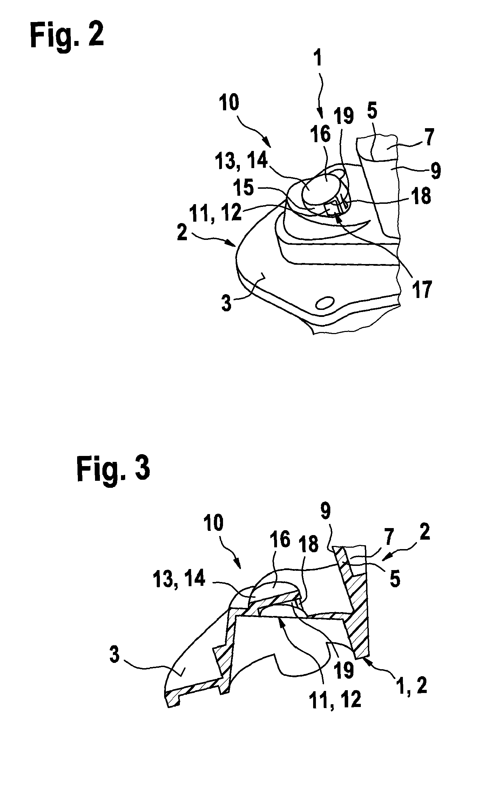

Wie in der Figur 2 im Detail dargestellt, weist das Druckausgleichselement 10 eine semipermeable Membran 11 als Druckausgleichsmembran 12 auf, die von einem als Schutzkappe 13 ausgebildeten Schutzelement 14 überdeckt wird. Die Membran 11 und die Schutzkappe 13 sind im Wesentlichen kreiszylinderförmig ausgebildet, wobei die Schutzkappe 13 die Membran 11 umschließt. Dabei weist die Schutzkappe eine im Wesentlichen kreiszylinderförmige Seitenwand 15, die von der Oberfläche 3 des Gehäuses 1 vorsteht, und eine die Schutzkappe 13 nach oben abschließende Schutzplatte 16 auf. In der Seitenwand 15 der Schutzkappe 13 sind zwei Druckausgleichsöffnungen 17 und 18 ausgebildet, die im Wesentlichen in Richtung der Steck-Anschlussvorrichtung 5 weisen. Die Schutzplatte 16 ist derart beabstandet zu der semipermeablen Membran 11 angeordnet, dass zwischen der Membran 11 und der Schutzkappe 13 ein Zwischenraum 19 gebildet ist, der eine Bewegung der Membran 11 aus ihrer Ruhelage erlaubt.

Wird das Gehäuse 1 zum Abdichten eines Steuergerätes eines Kraftfahrzeugs verwendet, so erlaubt die semipermeable Membran 11 einen Druckausgleich zwischen dem Inneren des Steuergeräts und seiner Umgebung, indem sie zum Beispiel Luft und Wasserdampf passieren lässt und insbesondere ein Eindringen einer Flüssigkeit in das Steuergerät verhindert. Dadurch ist die von dem Gehäuse umgebende Schaltung vorteilhaft vor Äußeren Einflüssen, wie Schmutz oder Flüssigkeiten geschützt. Gleichzeitig wird durch das Druckausgleichselement 10 gewährleistet, dass auf Grund von Temperatur- und Druckschwankungen Dichtungen und Verbindungsstellen des Gehäuses 1 nicht überlastet werden. Die Schutzkappe 13 des Druckausgleichselement, die vorteilhafterweise einstückig mit dem Gehäuse 1 ausgebildet ist, dient dabei als Schutzelement 14 für die semipermeable Membran 11 derart, dass kein direkter Zugriff (von oben) auf die Membran 11 möglich ist. So wird beispielsweise durch die Schutzkappe 13 verhindert, dass ein Wasserstrahl direkt auf die Membran 11 trifft.

Durch die Anordnung des Druckausgleichselements 10 neben der Steck-Anschlussvorrichtung 5 und durch die in Richtung der Steck-Anschlussvorrichtung 5 weisenden Druckausgleichsöffnungen 17 und 18 der Schutzkappe 13 beziehungsweise des Druckausgleichselements 10, wird dieser Schutz noch verstärkt. Hierbei wirkt der Haltevorsprung 9 der Steck-Anschlussvorrichtung 5 als weiteres Schutzelement für die semipermeable Membran, da ein Zugriff auf die Membran 11 weiter erschwert wird. In einer weiteren, hier nicht dargestellten, Ausführungsform ist der Haltevorsprung 9 derart ausgebildet, dass er ein Element aufweist, welches das Druckausgleichselement 10 zumindest bereichsweise überdeckt, um einen Zugriff auf die Membran 11 noch wirkungsvoller zu verhindern. Alternativ dazu kann das Druckausgleichselement 10 von einem in die Steck-Anschlussvorrichtung 5 eingesteckten Stecker überdeckt werden, um den Schutz zu erhöhen.

In dem hier dargestellten Ausführungsbeispiel ist das Druckausgleichselement 10 integriert in das Gehäuse 1 ausgebildet. Es ist jedoch auch denkbar, das Druckausgleichselement 10 als ein Druckausgleichsmodul an einem entsprechenden Gehäuse zu befestigen.

Die semipermeable Membran 11 ist in das Gehäuse eingeschweißt, so dass sie eine Öffnung 20 des Gehäuses 1 verschließt. Alternativ kann die Membran 11 auch an dem Gehäuse verklebt oder eingepresst werden. Auch kann die Membran 11 durch Umspritzen mit einem vorteilhaften Werkstoff an dem Gehäuse 1 befestigt werden. Durch die einfach Ausbildung des Druckausgleichselements und die vorteilhafte Anordnung neben der Steck-Anschlussvorrichtung werden keine zusätzlichen Anbauteile benötigt, um einen ausreichenden Schutz zu gewährleisten.

Die Figur 3 zeigt das Druckausgleichselement 10 aus den Figuren 1 und 2 in einer Schnittdarstellung. Die semipermeable Membran 11 ist unter der Schutzkappe 13 beziehungsweise in dem Gehäuse 1 geneigt angeordnet. Wobei die Membran 11 in Richtung der Druckausgleichsöffnungen 17 und 18 nach unten geneigt ist. Dies führt vorteilhaft dazu, dass zum Beispiel Flüssigkeit, die in den Zwischenraum 19 gelangt ist, auf der semipermeablen Membran 11 in Richtung der Druckausgleichsöffnungen 17, 18 abläuft und dort aus dem Zwischenraum 19 beziehungsweise dem Druckausgleichselement 10 austreten kann. In fast allen Einbaulagen des Gehäuses 1 wird dadurch gewährleistet, dass sich keine Flüssigkeit oder Schmutz auf der Membran 11 beziehungsweise in dem Zwischenraum 19 des Druckausgleichselements 10 festsetzt, wodurch die Funktion der semipermeablen Membran 11 beziehungsweise des Druckausgleichselements 10 gehemmt werden könnte. Vorteilhafterweise ist die Neigung so gewählt, dass ein Ablaufen von Flüssigkeit und/oder Schmutz von der Membran 11 im Eingebauten Zustand des Gehäuses 1 gewährleistet ist.

## Patentansprüche

1. Gehäuse für eine elektrische/elektronische Schaltung, mit zumindest einer elektrischen Steck-Anschlussvorrichtung (4,5) und mindestens einem Druckausgleichselement (10), das eine semipermeable Membran (11) aufweist, die mittels eines Schutzelements (14) abgedeckt ist, wobei das Schutzelement (14) neben der Steck-Anschlussvorrichtung (5) angeordnet ist und mindestens eine Druckausgleichsöffnung (17,18) aufweist, **dadurch gekennzeichnet, dass** die Druckausgleichsöffnung (17,18) in Richtung auf die Steck-Anschlussvorrichtung (5) weist, und dass die semipermeable Membran (11) geneigt angeordnet ist.

2. Gehäuse nach Anspruch 1, **dadurch gekennzeichnet, dass** die Steck-Anschlussvorrichtung (4,5) von einer, insbesondere nach außen weisenden Oberfläche (3) des Gehäuses (1) vorsteht.

3. Gehäuse nach einem der vorhergehenden Ansprüche, **dadurch gekennzeichnet, dass** die Steck-Anschlussvorrichtung (4,5) einstückig mit dem Gehäuse (1) ausgebildet ist.

4. Gehäuse nach einem der vorhergehenden Ansprüche, **dadurch gekennzeichnet, dass** Schutzelement (14) als Schutzkappe (13) ausgebildet ist.

5. Gehäuse nach einem der vorhergehenden Ansprüche, **dadurch gekennzeichnet, dass** die Schutzkappe (13) einstückig mit dem Gehäuse (1) ausgebildet ist.

6. Gehäuse nach einem der vorhergehenden Ansprüche, **dadurch gekennzeichnet, dass** zwischen der Schutzkappe (13) und der semipermeablen Membran (11) ein Zwischenraum (19) ausgebildet ist.

7. Gehäuse nach einem der vorhergehenden Ansprüche, **dadurch gekennzeichnet, dass** das Druckausgleichselement (10) geneigt angeordnet ist.

8. Gehäuse nach einem der vorhergehenden Ansprüche, **dadurch gekennzeichnet, dass** die semipermeable Membran (11) an dem Gehäuse (1) durch eine Schweißung, Klebung, Pressung und/oder mittels einer Stoffumspritzung befestigt ist.

9. Gehäuse nach einem der vorhergehenden Ansprüche, **gekennzeichnet durch** die Ausbildung als Messerleiste (2).

10. Steuergerät, insbesondere eines Kraftfahrzeugs, **gekennzeichnet durch** ein Gehäuse (1) nach einem oder mehreren der vorhergehenden Ansprüche.

## Claims

1. Housing for an electrical/electronic circuit, having at least one electrical plug-in connection device (4, 5) and at least one pressure-equalizing element (10) which has a semi-permeable membrane (11) which is covered by means of a protective element (14), wherein the protective element (14) is arranged adjacent to the plug-in connection device (5) and has at least one pressure-equalizing opening (17, 18), **characterized in that** the pressure-equalizing opening (17, 18) points in the direction of the plug-in connection device (5) and **in that** the semi-permeable membrane (11) is arranged in an inclined manner.

2. Housing according to Claim 1, **characterized in that** the plug-in connection device (4, 5) projects from a surface (3), in particular an outwardly pointing surface, of the housing (1).

3. Housing according to either of the preceding claims, **characterized in that** the plug-in connection device (4, 5) is formed in one piece with the housing (1).

4. Housing according to any of the preceding claims, **characterized in that** the protective element (14) is designed as a protective lid (13).

5. Housing according to any of the preceding claims, **characterized in that** the protective lid (13) is formed in one piece with the housing (1).

6. Housing according to any of the preceding claims, **characterized in that** an intermediate space (19) is formed between the protective lid (13) and the semi-permeable membrane (11).

7. Housing according to any of the preceding claims, **characterized in that** the pressure-equalizing element (10) is arranged in an inclined manner.

8. Housing according to any of the preceding claims, **characterized in that** the semi-permeable membrane (11) is fastened on the housing (1) by welding, adhesive-bonding, pressing and/or extrusion coating.

9. Housing according to any of the preceding claims, **characterized by** the design as multi-pole plug-in connector (2).

10. Control device, in particular of a motor vehicle, **characterized by** a housing (1) according to one or more of the preceding claims.

## Revendications

1. Boîtier pour un circuit électrique/électronique, avec au moins un dispositif de connexion électrique enfichable (4, 5) et au moins un élément de compensation de pression (10) présentant une membrane semi-perméable (11), laquelle est recouverte au moyen d'un élément de protection (14), dans lequel l'élément de protection (14) est disposé à côté du dispositif de connexion enfichable (5) et présente au moins une ouverture de compensation de pression (17, 18), **caractérisé en ce que** l'ouverture de compensation de pression (17, 18) est orientée en direction du dispositif de connexion enfichable (5) et **en ce que** la membrane semi-perméable (11) est disposée de manière inclinée.

2. Boîtier selon la revendication 1, **caractérisé en ce que** le dispositif de connexion enfichable (4, 5) est en saillie par rapport à une surface (3), en particulier orientée vers l'extérieur, du boîtier (1).

3. Boîtier selon l'une des revendications précédentes, **caractérisé en ce que** le dispositif de connexion enfichable (4, 5) est réalisé d'un seul tenant avec le boîtier (1).

4. Boîtier selon l'une des revendications précédentes, **caractérisé en ce que** l'élément de protection (14) est réalisé en tant que couvercle de protection (13).

5. Boîtier selon l'une des revendications précédentes, **caractérisé en ce que** le couvercle de protection (13) est réalisé d'un seul tenant avec le boîtier (1).

6. Boîtier selon l'une des revendications précédentes, **caractérisé en ce qu'**un espace intermédiaire (19) est réalisé entre le couvercle de protection (13) et la membrane semi-perméable (11) .

7. Boîtier selon l'une des revendications précédentes, **caractérisé en ce que** l'élément de compensation de pression (10) est disposé de manière inclinée.

8. Boîtier selon l'une des revendications précédentes, **caractérisé en ce que** la membrane semi-perméable (11) est fixée au boîtier (1) grâce à un soudage, un collage, un pressage et/ou au moyen d'un enrobage par injection de matière.

9. Boîtier selon l'une des revendications précédentes, **caractérisé par** la réalisation en tant que réglette de contacts à couteaux (2).

10. Appareil de commande, en particulier d'un véhicule automobile, **caractérisé par** un boîtier (1) selon l'une ou plusieurs des revendications précédentes.
